# Europäisches Patentamt

## European Patent Office
## Office européen des brevets

(11) Publication number: **0 108 518**
**B1**

(12) EUROPEAN PATENT SPECIFICATION

(45) Date of publication of patent specification: **18.01.89**

(21) Application number: **83306140.1**

(22) Date of filing: **11.10.83**

(51) Int. Cl.⁴: **H 01 R 4/70, H 02 G 15/00**

(54) Apparatus for protection of a substrate.

(30) Priority: **12.10.82 US 434011**
**13.06.83 US 504000**
**23.06.83 US 507433**
**23.06.83 US 507435**

(43) Date of publication of application:
**16.05.84 Bulletin 84/20**

(45) Publication of the grant of the patent:
**18.01.89 Bulletin 89/03**

(84) Designated Contracting States:
**AT BE CH DE FR IT LI NL SE**

(56) References cited:
**FR-A-2 245 101**
**GB-A-1 303 581**
**US-A-4 375 521**

(73) Proprietor: **RAYCHEM CORPORATION (a Delaware corporation)**
**300 Constitution Drive**
**Menlo Park, California 94025 (US)**

(72) Inventor: **Debbaut, Christian A.M.-L.**
**11, Kiernan Choice**
**Cary North Carolina 27511 (US)**
Inventor: **Uken, William David**
**4159 Lenwood Street**
**Fremont California 94538 (US)**

(74) Representative: **Benson, John Everett et al**
**Raychem Limited Intellectual Property Law Department Swan House 37-39, High Holborn London WC1 (GB)**

## Description

The present invention relates to apparatus and a method for protecting substrates, for example, electrically conductive substrates.

A wide variety of substrates require protection from adverse environmental conditions, including moisture, insects, dirt, plant life and corrosion deposits. In some cases, especially when electrical contacts are to be protected, it is desirable to provide a removable protective cover over the substrate, so that it is possible easily to reenter and work on the sealed substrate. It is known to use greases to protect electrical contacts, the grease being contained in a container which is applied to the electrical contact(s) — see for example US—A—3,897,129 (Farrar) and GB—A—1303581. However, the grease is a thixotropic fluid, which places limitations on the ways in which it can be used. Furthermore, when reentry to the sealed contact is required, when the container is removed, grease remains coated on the contact(s) and must be cleaned off before electrical work can begin. It is also known to encapsulate electrical contacts within a container by means of a two-part liquid composition prepared by mixing ingredients which will react slowly together. Before the ingredients have gelled, the mixture is poured into the container, where it cures in situ to form a hard gel — see US—A—4,375,521 (Arnold) and US—A—4,102,716 (Graves). However, this procedure involves preparation of the liquid composition at the site, delay while the composition gels, and the need to provide a container around the contact(s), into which the composition can be poured.

Furthermore, when reentry to the encapsulated contacts is required, the gelled composition cannot easily be removed.

We have now discovered that excellent encapsulation of electrical contacts (and other substrates, for example one or more discrete or modular conventional electrical connectors) can be obtained through the use of gels (and like compositions) which have been pre-formed in the absence of the substrate. The encapsulant is adherent to a support member, and the support member and the substrate to be encapsulated are pressed against each other, thus deforming the encapsulant into close and conforming contact with the substrate. Preferably, at least a part of the deformation is elastic deformation. The preferred properties of the encapsulant depend upon the substrate to be encapsulated, as further discussed below, but we have found that in all cases, it is essential for the encapsulant to be relatively soft by comparison with the gels formed in situ in the known processes. Thus the gels formed in situ have cone penetration values of less than 75, whereas the encapsulants used in this invention have cone penetration values of at least 100. Cone penetration values given in this specification are expressed in units of $10^{-1}$ mm and are measured by ASTM D217—68 at 70°F ± 5°F (22 ± 2°C) on an undisturbed sample using a standard 1:1 scale cone (cone weight 102.5 g, shaft weight 47.5 g), the penetration being measured after 5 seconds. In addition, the encapsulant should preferably have an elongation of at least 200%. Elongation values given in this specification are ultimate elongations measured by ASTM D638—80 at 70°F ± 5°F (22 ± 2°C) using a Type 4 die to cut the sample and at a speed of 50 cm/minute.

The encapsulant can be adherent to any suitable support member. Especially when it is desirable that the encapsulant should be removable from the electrical contact or other substrate which it is protecting, the encapsulant preferably has an adhesive strength to the substrate which is less than its adhesive strength to the support member and less than its cohesive strength, so that the encapsulant can be cleanly removed from the substrate merely by separating the support member and the substrate, leaving little or none of the encapsulant on the substrate. When the encapsulation of the substrate involves pushing at least part of the substrate through the encapsulant so that the encapsulant is parted and then flows back to form a seal on the other side of the substrate, the seal is a plane of weakness which will in many cases separate cleanly when the encapsulant is removed. This is in contrast to the situation when an encapsulant is gelled in situ, when no such plane of weakness exists.

In one aspect, the present invention provides an apparatus for providing a protective covering over a substrate, the apparatus comprising a support member and an encapsulant, the encapsulant being adherent to the support member and being composed of a material which has a cone penetration value of 100 to 350 and an ultimate elongation of at least 200%, and means for deforming the encapsulant into close and conforming contact with the substrate.

In another aspect, the invention provides a method of protecting a substrate which comprises pressing together (i) the substrate and (ii) an apparatus comprising a support member and an encapsulant, the encapsulant being adherent to the support member and having a cone penetration value of 100 to 350 ($10^{-1}$ mm) and an ultimate elongation of at least 200%, so that the encapsulant contacts the substrate and is deformed into close and conforming contact therewith.

The encapsulants used in the present invention have cone penetration values of 100 to 350, with values of 150 to 350, especially 200 to 300, being preferred for processes in which the pressure exerted on the encapsulant during installation is relatively low, as for example in the encapsulation of electrical terminals as described below. When the volume of the encapsulant (or each mass of encapsulant) is relatively large (e.g. more than 3 cm³), the cone penetration value is preferably 200 to 250. When the volume is relatively small (e.g. less than 3 cm³) the cone penetration value is preferably 250 to 350.

The elongation of the encapsulant is at least 200%, and substantially higher values are preferred, e.g. at least 500%, particularly at least 750%. The tensile strength of the encapsulant is generally less, often very much less, than 20 psi (approx 1.5 bar) (measured by ASTM D638—80 under the same conditions as the elongation).

The elastic modulus of the encapsulant is also significant, since it affects the ability of the encapsulant to make intimate contact with the substrate. When measured at 70°F ± 5°F (22 ± 2°C), using a parallel plate rheotmetric test at a frequency of 1 Hz, the encapsulant generally has an elastic modulus less than $10^7$ dynes/cm$^2$, preferably less than $10^6$ dynes/cm$^2$, particularly less than $10^5$ dynes/cm$^2$.

The encapsulant is usually electrically insulating (i.e. has a resistivity of at least $10^9$ ohm/cm), but is not necessarily so for some possible uses of the invention, e.g. when non-electrical substrates are being protected. Suitable encapsulants include materials made by gelling curable polyurethane precursor materials (as described for example in the patents referenced above) in the presence of substantial quantities of a mineral oil, a vegetable oil or a plasticizer, or a mixture of two or more of these. Thus we have obtained excellent results using encapsulants prepared by gelling components which are commercially available for the preparation of polyurethane gels *in situ*, the gelation being carried out, however, in the presence of a suitable amoiunt, e.g. 30 to 70% by weight, of a suitable plasticizer, e.g. a trimellitate, or in the presence of a suitable animal or vegetable oil, e.g. 80 to 60%, preferably 80 to 70%, by weight of a mixture of mineral and vegetable oils in which the ratio by weight of mineral oil to vegetable oil is 0.7 to 2.4. Suitable encapsulants can also be prepared by curing reactive silicones with non-reactive extender silicones, and the invention includes the use of any encapsulant having the desired cone penetration and elongation values. The encapsulant may contain known additives such as moisture scavengers (e.g. benzoyl chloride), antioxidants, pigments and fungicides. The encapsulant is preferably hydrolytically stable, moisture-insensitive, and substantially inert towards the substrate.

A wide variety of support members are useful in the present invention. The support member can be of any material, but preferably it is composed of an organic polymer or some other insulator. The surface of the support which contacts the encapsulant can if desired comprise means for promoting adhesion to the encapsulant. For example the surface can be physically and/or chemically modified for this purpose, as by roughening or shaping the surface or by subjecting the surface to a chemical or corona discharge treatment.

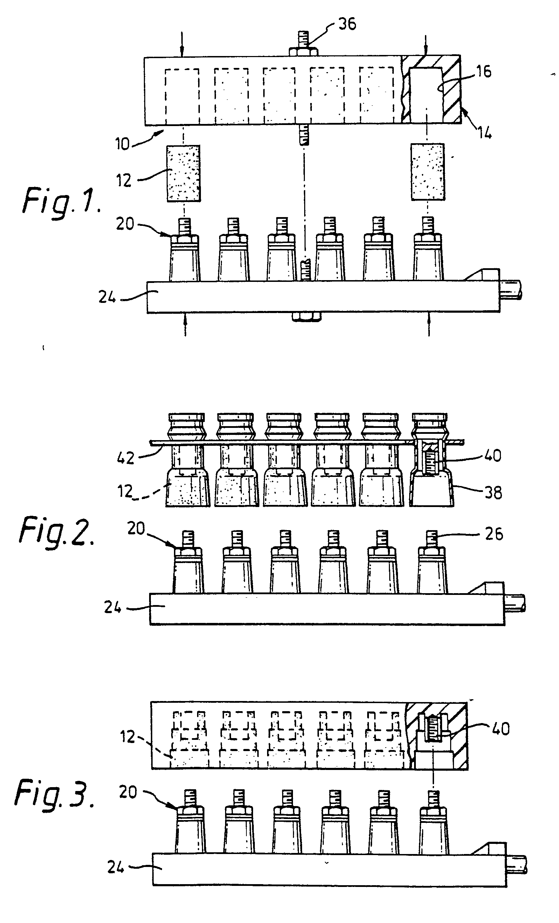

In some cases a conventional, e.g. rectangular, container, having side walls, end walls and a bottom wall, is a satisfactory support member. The container may be partitioned, e.g. as shown in Figure 1.

In a second embodiment, as shown for example in Figure 2, which is particularly useful when a plurality of adjacent electrical contacts are to be encapsulated, the support member comprises a plurality of individual open containers, which are connected to each other, e.g. through a flexible connection means, and each of which contains a separate mass of encapsulant. The separate containers can be applied simultaneously or sequentially to the contacts.

In a third embodiment, the support member is recoverable, preferably heat-recoverable, in which case the process for applying the protective covering to the substrate includes a step in which the support member is recovered. When using a recoverable substrate, the elastic modulus of the encapsulant is particularly important, but the elongation can be substantially less than 200%, e.g. as little as 50%, though preferably at least 100%. A particular advantage of this embodiment, by comparison with a conventional heat-shrinkable article having a layer of hot melt adhesive as sealant on its interior surface, is that additional heat input is not required in order to melt the sealant; this is particularly advantageous when the substrate is a metal pipe or other substrate which acts as a heat sink.

In a fourth embodiment, the encapsulant is supported by and distributed in a flexible matrix which comprises a plurality of open interstices, the interstices having an average volume of less than 0.01, particularly less than 0.001, inch$^3$ (0,0025 cm$^3$). The encapsulant comprises a plurality of interconnected segments which lie within the interstices of the matrix. The interconnections may be through openings in shared walls of adjacent interstices (as for example when the matrix is an open-celled foam) and/or through a surface layer of encapsulant which connects segments of encapsulant which lie in adjacent interstices which may or may not communicate with each other (as for example when the support member is a woven fabric). The presence of a continuous layer of encapsulant on the surface of the apparatus adjacent the substrate is preferred. The ultimate elongation of the matrix is preferably less than the ultimate elongation of the encapsulant, and the ratio by volume of the encapsulant to the matrix is preferably at least 7.0, particularly at least 9.0, especially at least 9.5.

The matrix is preferably in the form of a sheet (this term being used to include tape), the sheet preferably having a thickness of 10 to 300 mils (0.025 to 0.76 cm), particularly 15 to 80 mils (0.04 to 0.20 cm), and the sheet preferably being extensible with an ultimate elongation which is preferably at least 50%, particularly at least 100%. The sheet can be directly applied to a substrate in a manner similar to the way an adhesive tape or band-aid is applied to a substrate to be protected. The sheet can be wrapped around a substrate, preferably in overlapping spiral wraps, and will form a thin, conforming and preferably continuous protective coating over the substrate.

Any stretching which the sheet undergoes during this process should be less than the ultimate elongation of the matrix and less than the ultimate elongation of the encapsulant. If desired or necessary, additional means can be used to secure the wrapping in place, but in general the sheet will adhere to itself and to the substrate, making such additional means unnecessary. Furthermore, the sheet can usually subsequently be removed, e.g. unwrapped or cut off, and cleanly pealed away from the substrate. Substrates which can be covered in this way can be of regular or irregular shape and include for example a punctured telephone cable or a splice between two cables.

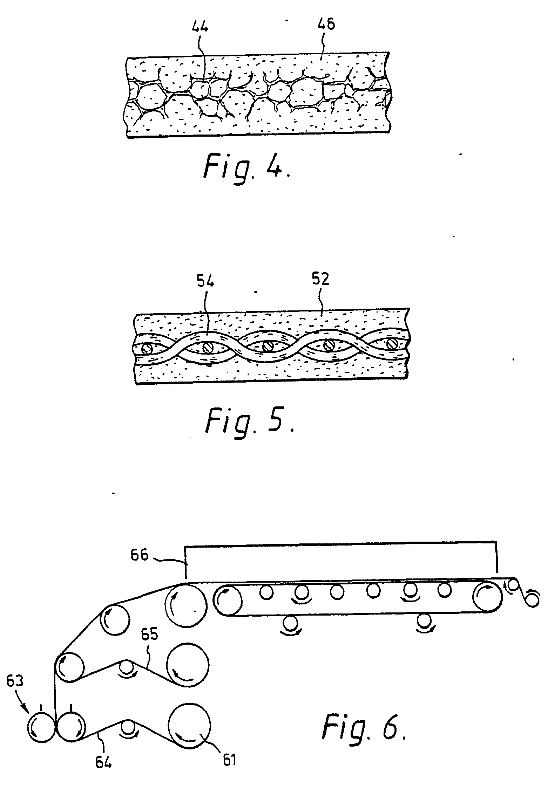

A particularly preferred support member for this embodiment of the invention (as illustrated for example in Figure 4) is an open cell foam sheet of an organic polymer, e.g. a polyurethane, in particular an open cell foam having an average cell size of 5 to 30 mils (0.013 to 0.076 cm), preferably 10 to 20 mils (0.025 to 0.05 cm). Another useful support member, (as illustrated for example in Figure 5) is a woven or non-woven fabric comprising fibers which are natural or synthetic and composed of organic or inorganic material, e.g. glass fibers, metal fibers or organic polymer fibers. The foam sheet or fabric may be for example 5 to 60 mils (0.013 to 0.15 cm), particularly 10 to 50 mils (0.025 to 0.125 cm), thick. When the fabric comprises metal fibers, the apparatus may be useful, for example, in providing electrical shielding over a substrate.

Alternatively, the flexible matrix forms at least a surface portion of a block or other three-dimensional article. For example, the flexible matrix can provide the lining of a concave portion of an article designed to provide a protective cover over a substrate comprising a protruding member, e.g. an electrical contact on a terminal block. The thickness of the surface portion can be, for example, at least 5 mils (0.013 cm), preferably 5 to 60 mils (0.013 to 0.15 cm). The matrix is preferably an open cell foam as described above. The remainder of the article can, for example, comprise resilient material, e.g. a closed cell foam, which helps to bring the article into close and conforming contact with a substrate to be protected. The article can comprise a relatively rigid outer or inner shell which provides a bearing surface for pressing the matrix against the surface to be protected.

In a fifth embodiment of the invention, the support member is an electrical connector which can connect two or more electrical wires and/or an insulating member adapted to retain the connector, the encapsulant being disposed within the connector and/or insulating member. The apparatus of this embodiment can be used to connect two or more electrical wires by a process which comprises

a) inserting end sections of the wires into an apparatus that comprises:

(i) an electrical connector;

(ii) an insulating member that surrounds and retains the electrical connector; and

(iii) an encapsulant as defined within the insulating member; and

b) exerting pressure on the electrical connector through the insulating member, thereby connecting the electrical wires and encapsulating the electrical connection within the encapsulant.

The connector can be a crimp connector which can be permanently deformed by pressure, e.g. an in-line crimp splicer, a B-wire connector or a pigtail connector. Such connectors generally comprise a tubular member composed of a ductile metal, e.g. copper, aluminum or brass, and an insulating sleeve which surrounds the metal member and through which the necessary crimping force can be transmitted; suitable materials for the sleeve include polyamides and polyvinylidene fluoride. When the connector is crimped, the encapsulant does not have an adverse effect on the quality of the electrical connection.

The connector can also be a modular connector in which a plurality of pairs of wires are connected simultaneously. The connections can be permanent or reenterable. In the latter case, the insulating member can comprise two portions which are movably joined together, e.g. in the form of a clam shell, with respective portions of the connector mounted on each portion.

The end sections of the wires can be stripped of insulation before being inserted into the connector, which mechanically deforms the end sections so that they are in physical as well as electrical contact. Alternatively the insulation can be left on the wires, in which case the connector must comprise an insulation displacing member which, when the connector is crimped, displaces insulation on the end sections and effects electrical connection between the wires.

In all the embodiments of the invention, the surface(s) of the encapsulant which do not contact the support member can be covered by a release sheet which is removed before the protective apparatus is used. Such a release sheet may be unnecessary or even disadvantageous when the encapsulant lies wholly within a container-shaped support member. On the other hand, when the encapsulant protrudes from the support member, and especially when the encapsulant is sticky (as are the polyurethane gels referred to above), the use of a release sheet may be essential or highly desirable if a number of protective members are to be stored together.

Especially when at least part of the deformation of the encapsulant is elastic deformation, and the support member does not surround the substrate, it is often necessary to provide a force member for maintaining the encapsulant in compressive contact with the substrate. The force member is preferably secured to or forms part of the support member, but can be separate from it. The force member can be such that it becomes secured to the substrate when the substrate and the protective apparatus are pressed together. For example the force member can lie within the encapsulant and engage the substrate to which the encapsulant is applied.

Apparatus of the present invention can readily be prepared by (1) placing in or on the support member a curable liquid composition which, when cured, will have the desired cone penetration and elongation values and (2) curing the liquid composition.

The invention is illustrated in the accompanying drawings. Referring now to Figure 1, this is an exploded view of an apparatus 10 of the invention which is secured to a terminal block 24 having a plurality of terminals 20. The apparatus 10 comprises a plurality of masses of encapsulant 12 contained within a partitioned housing 14. As indicated by numeral 16, the inside surfaces of the partitions comprise means for promoting adhesion of the encapsulant to the housing. The masses of encapsulant 12 have been elastically deformed into close and conforming contact with the terminals 20, and are maintained in compressive contact therewith by nut-and-bolt assembly 36 (which is a force member as referred to above) which acts on all the masses of encapsulant via the housing 14. If the assembly 36 is undone, and the apparatus 10 is removed from the terminal block 10, the encapsulant is cleanly removed from each of the terminals. This is a very valuable feature because the terminals are immediately ready for electrical connection or disconnection. Furthermore the sequence of protection and removal can be frequently repeated.

Referring now to Figure 2, this is an exploded view of another apparatus of the invention which is secured to a terminal block 24 having a plurality of terminals 20. The apparatus comprises a plurality of individual bell-shaped housings 38, each of which contains a mass of encapsulant 12 and which are joined together by means of a flexible ribbon 42. Within each of the housings 38 is a split retaining nut member 40 which engages the threaded part 26 of the corresponding terminal. When the housing is pressed onto the contact, the encapsulant 12 is elastically deformed around the terminal 20 and the end portion engages the member 40, thus maintaining the encapsulant 12 in compressive contact with the terminal 20. The housings 38 can be removed individually, so that other terminals are not affected, or can be removed together.

Referring now to Figure 3, this is similar to Figure 1, but with the important difference that the nut-and-bolt assembly is not present, and each of the compartments includes a split retaining nut member 40 for maintaining the encapsulant in compressive contact with the terminals. Note, in this regard, that a split retaining nut member 40, may, by reason of its geometry, cause the encapsulant 12 to undergo plastic deformation, thereby voiding the encapsulant 12 from the substrate. This voiding process, which may affect the encapsulation of the substrate, is, in general, minimized by providing a force means, for example three to six ribs extending radially from the wall of the housing, wherein the encapsulant 12 does not undergo plastic deformation when the support member is pressed onto the substrate.

Referring now to Figure 4, this shows in cross-section apparatus of the invention comprising an open-cell polymeric foam matrix support member 44 and an encapsulant 46 which is supported by and distributed in the support member 44.

Referring now to Figure 5, this shows in cross-section apparatus of the invention similar to that shown in Figure 5 and comprising a woven fabric matrix support member 54 and an encapsulant 52 which is supported by and distributed in the support member 54.

Referring now to Figure 6, this shows the preparation of apparatus of the type shown in Figure 4. A foam sheet 64 is withdrawn from roll 61 and is passed through coating station 63 where a liquid mixture of gel precursors is impregnated through the foam. A release sheet 65 is then laminated to the impregnated sheet, and the laminate is passed through oven 66 where the gel is cured.

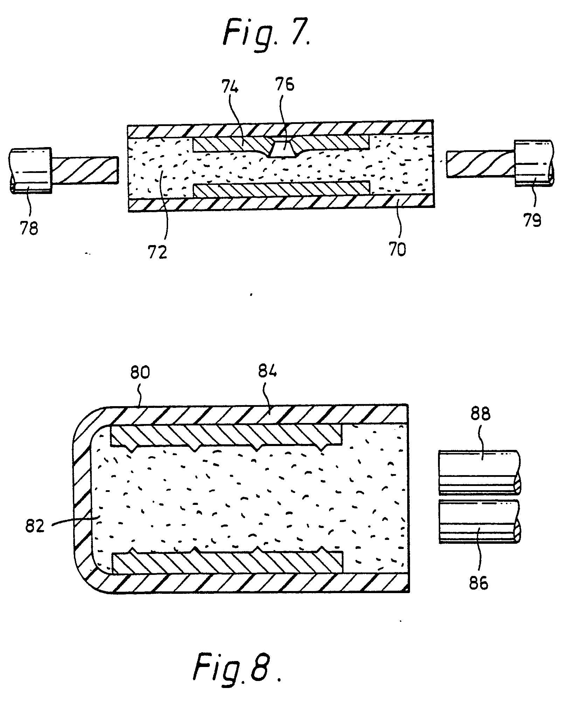

Referring now to Figure 7, this shows in cross-section apparatus of the invention which comprises a deformable metal connector 74 having a central stop 76, an insulating sleeve 70 surrounding the connector, and encapsulant 72 which fills the sleeve 70. This connector is suitable for connecting conductors 78 and 79. When these conductors are inserted into the connector, the encapsulant shears to allow the conductors to butt up against the stop, and seals behind them. Furthermore, when the connector is crimped, the encapsulant does not substantially interfere with the electrical connection of the wires. Furthermore, the encapsulant not only forms an environmental seal but also helps to prevent relative movement of the wires and the connector which will adversely affect the joint.

Referring now to Figure 8, this shows in cross-section another apparatus comprising a deformable metal connector 84, an insulating cap 80 surrounding the connector, and an encapsulant 82 filling the cap 80. The connector 84 comprises insulation-displacing members which make the connector suitable for connecting fully insulated conductors 86 and 88.

The invention is further illustrated by the following Example.

Example

A commercially available polymeric foam sheet material ("Pro Wrap") was used as the matrix for preparation of this aspect of the invention. The foam material had a thickness of 15—20 mils (0.04—0.05 cm), an average cell size of 5—10 mils (i.e. it was 2—3 cells thick), about 96% by volume of voids, and a density of about 0.044 g/cm³. It is believed to be a polyurethane material. A strip of the foam was placed on a surface having a release coating thereon, and was then knife-coated with a composition comprising a mixture of a commercially available polyurethane precursor ("Gella" available from Minnesota Mining and Manufacturing Co.) and about 50—55% by weight of a plasticizer for the polyurethane (n-octyl-n-decyl trimellitate). Samples were cured in an oven at 100°C. The resulting products were 40—50 mils (0.1—0.125 cm) thick. When one of the products was wrapped around a cable TV connector in an overlapping spiral, it stretched easily to accommodate the irregularities of the connector and formed an excellent sealed protective covering over the connector.

**Claims**

1. An apparatus (10) for protecting a substrate (20, 78, 79, 86, 82) comprising:
   a support member (14, 38, 44, 74/70, 84/80)
   an encapsulant (12, 46, 72, 82) which is adherent to the support member (14, 46, 72, 82) has a cone penetration value of 100 to 350 ($10^{-1}$ mm) and an ultimate elongation of at least 200%, and
   means (14/36, 38/40) for deforming the encapsulant into close and conforming contact with the substrate.

2. An apparatus (10) as recited in claim 1, wherein said support member comprises a plurality of individual open containers (38), which are connected to each other by a flexible connecting means (42), and each of which contains a separate mass of encapsulant (12).

3. An apparatus as recited in claim 1, wherein said support member is a flexible matrix (44) which comprises a plurality of open interstices, the interstices having an average volume of less than 0.01 inch$^3$ (0.025 cm$^3$), and wherein said encapsulant (46) comprises a plurality of interconnected segments which lie within the interstices of the matrix; the matrix and the impregnated encapsulant being such that when the article is stretched, the matrix reaches its ultimate elongation before the impregnated encapsulant reaches its ultimate elongation.

4. An apparatus according to claim 3, wherein the matrix (44) is an open cell polymeric foam.

5. An apparatus as recited in claim 1, wherein said support member (74/70, 84/80) comprises:
   a) an electrical connector (74, 84) which is adapted to receive electrical wires and electrically connect electrical wires received therein; and
   b) an insulating member (70, 80) adapted to surround and retain said connector; said encapsulant (72, 82) being disposed within at least one of said electrical connector and said insulating member.

6. An apparatus as recited in claim 1, wherein at least part of said support member is heat-recoverable.

7. An apparatus as recited in any one of the preceding claims wherein the encapsulant (12, 46, 72, 82) has an elastic modulus of less than $10^7$ dynes/cm$^2$.

8. An apparatus as recited in any one of the preceding claims wherein said cone penetration value is 150 to 350 ($10^{-1}$ mm).

9. An apparatus as recited in any one of the preceding claims wherein said encapsulant (12, 46, 72, 82) has an elongation of least 500%.

10. An apparatus as recited in any one of the preceding claims wherein the encapsulant (12, 46, 72, 82) is an oil-extended polyurethane.

11. An apparatus as recited in claim 10, wherein the encapsulant (12, 46, 72, 82) has been prepared by gelling a liquid mixture comprising 20 to 40% of curable polyurethane precursor materials and 80 to 60% of a mixture of mineral oil and vegetable oil in which the ratio by weight of mineral oil to vegetable oil is 0.7 to 2.4; the percentages being by weight based on the total weight of the polyurethane precursor materials and the mixture of mineral and vegetable oils.

12. An apparatus according to any preceding claim, wherein the encapsulant (12, 46, 72, 82) is cured prior to coming into contact with any part of a substrate to be protected.

13. A method of protecting a substrate (20, 78, 79, 86, 88) which comprises pressing together
   (i) the substrate and
   (ii) an apparatus (10) comprising a support member and an encapsulant, the encapsulant being adherent to the support member and having a cone penetration value of 100 to 350 ($10^{-1}$) and an ultimate elongation of at least 200%,
so that the encapsulant (12, 46, 72, 82) contacts the substrate and is deformed into close and conforming contact therewith.

**Patentansprüche**

1. Vorrichtung (10) zum Schutz eines Substrats (20, 78, 79, 86, 82), die aufweist:
   ein Stützteil (14, 38, 44, 74/70, 84/80),
   eine Umhüllung (12, 46, 72, 82), die haftend mit dem Stützteil (14, 46, 72, 82) verbunden ist, und die einen Konuspenetrationswert von 100 bis 350 ($10^{-1}$ mm) und eine maximale Dehnung von wenigstens 200% hat, und
   eine Einrichtung (14/36, 38/40) zur Verformung der Umhüllung in engen und angepassten Kontakt mit dem Substrat.

2. Vorrichtung (10) nach Anspruch 1, bei der das Stützteil eine Mehrzahl von einzelnen offenen Behältern (38) aufweist, die miteinander durch eine flexible Verbindungseinrichtung (42) verbunden sind, und die jeweils eine gesonderte Umhüllungsmasse (12) enthalten.

3. Vorrichtung nach Anspruch 1, bei der das Stützteil eine flexible Matrix (44) ist, die eine Mehrzahl von offenen Hohlräumen aufweist, wobei die Hohlräume ein mittleres Volumen von weniger als 0,01 inch$^3$ (0,025 cm$^3$) haben, und bei der die Umhüllung (46) eine Mehrzahl von untereinander verbundenen Segmenten aufweist, die in den Hohlräumen der Matrix liegen, wobei die Matrix und die imprägnierte Umhüllung derart gewählt sind, daß, wenn der Gegenstand gestreckt wird, die Matrix ihre maximale Dehnung erreicht, bevor die imprägnierte Umhüllung eine maximale Dehnung erreicht.

4. Vorrichtung nach Anspruch 3, bei der die Matrix (44) ein offenzelliger, polymerer Schaum ist.

5. Vorrichtung nach Anspruch 1, bei der das Stützteil (74/70, 84/80) aufweist:

(a) einen elektrischen Verbinder (74, 84), der derart beschaffen ist, daß er elektrische Leitungen aufnimmt und darin aufgenommene elektrische Leitungen elektrisch verbindet, und

(b) ein Isolierteil (70, 80), das derart beschaffen ist, daß es den Verbinder umgibt und festhält, wobei die Umhüllung (72, 82) in wenigstens einem der elektrischen Verbinder und dem isolierenden Teil angeordnet ist.

6. Vorrichtung nach Anspruch 1, bei der wenigstens ein Teil des Stützteiles wärmerückstellbar ist.

7. Vorrichtung nach einem der vorangehenden Ansprüche, bei der die Umhüllung (12, 46, 72, 82) ein Elastizitätsmodul von weniger als $10^7$ dyn/cm$^2$ hat.

8. Vorrichtung nach einem der vorangehenden Ansprüche, bei der der Konuspenetrationswert 150 bis 350 ($10^{-1}$ mm) beträgt.

9. Vorrichtung nach einem der vorangehenden Ansprüche, bei der die Umhüllung (12, 46, 72, 82) eine Dehnung von wenigstens 500% hat.

10. Vorrichtung nach einem der vorangehenden Ansprüche, bei der die Umhüllung (12, 46, 72, 82) ein ölgestrecktes Polyurethan ist.

11. Vorrichtung nach Anspruch 10, bei der die Umhüllung (12, 46, 72, 82) hergestellt ist durch Gelieren eines flüssigen Gemisches, das 20 bis 40% härtbare Polyurethanvorläufermaterialien und 80 bis 60% eines Gemisches von Mineralöl und pflanzlichem Öl enthält, wobei das Gewichtsverhältnis von Mineralöl zu pflanzlichem Öl 0,7 bis 2,4 beträgt und die Prozentangaben Gewichtsangaben sind, bezogen auf das Gesamtgewicht der Polyurethanvorläufermaterialien und des Gemisches von Mineralöl und pflanzlichen Ölen.

12. Vorrichtung nach einem der vorhergehenden Ansprüche, bei der die Umhüllung (12, 46, 72, 82) gehärtet ist, bevor sie in Kontakt mit irgendeinem Teil eines zu schützenden Substrates kommt.

13. Verfahren zum Schützen eines Substrates (20, 78, 79, 86, 88), bei dem zusammengepresst werden

(i) das Substrat, und

(ii) eine Vorrichtung (10), bestehend aus einem Stützteil und einer Umhüllung, wobei die Umhüllung haftend mit dem Stützteil verbunden ist und einen Konuspenetrationswert von 100 bis 350 ($10^{-1}$ mm) und eine maximale Dehnung von mindestens 200% hat, so dass die Umhüllung (12, 46, 72, 82) das Substrat kontaktiert und in engen und angepassten Kontakt mit ihm deformiert.

**Revendications**

1. Appareil (10) de protection d'un substrat (20, 78, 79, 86, 82), comprenant:

un élément de support (14, 38, 44, 74/70, 84/80),

un enrobant (12, 46, 72, 82) qui adhère à l'élément de support (14, 46, 72, 82) et présente une valeur de pénétration de cône de 100 à 350 ($10^{-1}$ mm) et un allongement à la rupture d'au moins 200%, et

des moyens (14/36, 38/40) destinés à déformer l'enrobant pour l'appliquer en contact étroit avec le substrat et lui faire épouser la forme de celui-ci.

2. Appareil (10) selon la revendication 1, dans lequel ledit élément de support comprend plusieurs récipients ouverts individuels (38) qui sont reliés les uns aux autres par un moyen flexible (42) de liaison et qui contiennent chacun une masse séparée d'enrobant (12).

3. Appareil selon la revendication 1, dans lequel ledit élément de support est une matrice flexible (44) qui présente plusieurs interstices ouverts, les interstices ayant un volume moyen de moins de 0,01 inch$^3$ (0,025 cm$^3$), et dans lequel ledit enrobant (46) comprend plusieurs segments interconnectés qui s'étendent à l'intérieur des interstices de la matrice; la matrice et l'enrobant imprégné étant tels que, lorsque l'article est étiré, la matrice atteint son allongement à la rupture avant que l'enrobant imprégné atteigne son allongement à la rupture.

4. Appareil selon la revendication 3, dans lequel la matrice (44) est une mousse polymérique à cellules ouvertes.

5. Appareil selon la revendication 1, dans lequel ledit élément de support (74/70, 84/80) comprend:

a) un connecteur électrique (74, 84) qui est conçu pour recevoir des fils électriques et pour connecter électriquement les fils électriques qu'il reçoit; et

b) un élément isolant (70, 80) conçu pour entourer et obtenir ledit connecteur; ledit enrobant (72, 82) étant disposé à l'intérieur d'au moins l'un dudit connecteur électrique et dudit élément isolant.

6. Appareil selon la revendication 1, dans lequel au moins une partie dudit élément de support est douée de reprise de forme par la chaleur.

7. Appareil selon l'une quelconque des revendications précédentes, dans lequel l'enrobant (12, 46, 72, 82) possède un module élastique de moins de $10^7$ dynes/cm$^2$.

8. Appareil selon l'une quelconque des revendications précédentes, dans lequel ladite valeur de pénétration de cône est de 150 à 350 ($10^{-1}$ mm).

9. Appareil selon l'une quelconque des revendications précédentes, dans lequel ledit enrobant (12, 46, 72, 82) présente un allongement d'au moins 500%.

10. Appareil selon l'une quelconque des revendications précédentes, dans lequel l'enrobant (12, 46, 72, 82) est un polyuréthanne allongé d'huile.

11. Appareil selon la revendication 10, dans lequel l'enrobant (12, 46, 72, 82) a été préparé par gélification d'un mélange liquide comprenant 20 à 40% de matières du type précurseur de polyuréthanne, durcissables, et de 80 à 60% d'un mélange d'huile minérale et d'huile végétale dans lequel le rapport en poids d'huile minérale à l'huile végétale est de 0,7 à 2,4; les pourcentages étant en poids, sur la base du poids total des matières du type précurseur de polyuréthanne et du mélange d'huiles minérale et végétale.

12. Appareil selon l'une quelconque des revendications précédentes, dans lequel l'enrobant (12, 46, 72, 82) est durci avant d'entrer en contact avec une partie quelconque d'un substrat à protéger.

13. Procédé de protection d'un substrat, (20, 78, 79, 86, 88), qui consiste à presser ensemble
i) le substrat et
ii) un appareil (10) comprenant un élément de support et un enrobant, l'enrobant adhérant à l'élément de support et ayant une valeur de pénétration de cône de 100 à 350 ($10^{-1}$) et un allongement à la rupture d'au moins 200%, de manière que l'enrobant (12, 46, 72, 82) entre en contact avec le substrat et soit déformé en contact étroit et en conformation avec celui-ci.

Fig.1.

Fig.2.

Fig.3.

44    46

Fig. 4.

54    52

Fig. 5.

66

65

63

64    61

Fig. 6.

2

## Fig. 7.

## Fig. 8.